Europäisches Patentamt

**European Patent Office**

Office européen des brevets

(11) Numéro de publication : **0 022 383**
**B1**

(12) **FASCICULE DE BREVET EUROPÉEN**

(45) Date de publication du fascicule du brevet :
20.04.83

(21) Numéro de dépôt : **80400816.7**

(22) Date de dépôt : **06.06.80**

(51) Int. Cl.³ : **H 01 L 29/80**

(54) **Procédé de réalisation d'un transistor à effet de champ à grille Schottky auto-alignée, et transistor obtenu par ce procédé.**

(30) Priorité : 06.07.79 FR 7917603

(43) Date de publication de la demande :
14.01.81 Bulletin 81/02

(45) Mention de la délivrance du brevet :
20.04.83 Bulletin 83/16

(84) Etats contractants désignés :
**DE GB IT NL**

(56) Documents cités :
**FR A 2 369 689**
**US A 4 156 879**

**SOLID-STATE TECHNOLOGY, vol. 22, no. 6, juin 1979 Port Washington New York US D. LEERS et al. : « Computer controlled optical microprojection system for one micron structures » pages 80-83**

**SIEMENS FORSCHUNGS- UND ENTWICKLUNGS-BERICHTE, vol. 5, no. 3, mars 1976 Berlin DE H. FELTL : « Fine-geometry Schottkygate FET in Ion Implantation technology for ISI », pages 136-138**

(73) Titulaire : **THOMSON-CSF**
**173, Boulevard Haussmann**
**F-75379 Paris Cedex 08 (FR)**

(72) Inventeur : **Lepage, Joel**
**"THOMSON-CSF" SCPI 173, bld Haussmann**
**F-75360 Paris Cedex 08 (FR)**
Inventeur : **Laviron, Michel**
**"THOMSON-CSF" SCPI 173, bld Haussmann**
**F-75360 Paris Cedex 08 (FR)**
Inventeur : **Derewonko, Henri**
**"THOMSON-CSF" SCPI 173, bld Haussmann**
**F-75360 Paris Cedex 08 (FR)**

(74) Mandataire : **Giraud, Pierre et al**
**THOMSON-CSF SCPI 173, Bld Haussmann**
**F-75379 Paris Cedex 08 (FR)**

## Procédé de réalisation d'un transistor à effet de champ à grille Schottky auto-alignée, et transistor obtenu par ce procédé

L'invention se rapporte aux procédés de réalisation de transistors à effet de champ dits « à auto-alignement » de la grille par rapport aux électrodes de source et de drain.

On connaît, par le document SIEMENS FORSCHUNGS und ENTWICKLUNGS-BERICHTE, vol. 5, N° 3, mars 1976, pages 136-138, un procédé de réalisation d'un transistor à effet de champ à grille Schottky, où la position et les dimensions de la grille, ainsi que les intervalles entre source et grille, grille et drain sont fixés dès la première opération de masquage par la réalisation de fenêtres de source, de grille et de drain dans un premier matériau. On utilise un même métal (le platine) pour réaliser les contacts ohmiques et Schottky, la différenciation des contacts étant obtenue grâce à un surdopage préalable des zones semiconductrices devant recevoir les contacts ohmiques.

Il est par ailleurs possible à l'homme de métier d'utiliser un procédé analogue à celui du document précité, en utilisant deux métaux différents, l'un formant un contact ohmique avec le matériau semiconducteur et l'autre formant un contact Schottky. Il utilisera à cet effet deux matériaux différents de masquage attaquables sélectivement par des agents de gravure différents.

Un inconvénient commun aux procédés précité provient du fait que la couche de matériau subsistant après le premier masquage et demeurant sur le transistor, même après finition, constitue une source de fêlures et de cassures dans la couche superficielle isolante du transistor par suite de la différence de dilatation thermique, notamment dans le cas des transistors à l'arséniure de gallium, particulièrement pour les transistors de forte puissance.

L'invention remédie à cet inconvénient en laissant subsister sur la couche active en arséniure de gallium du transistor à effet de champ, deux couches protectrices superposées formées l'une, d'arséniure de gallium polycristallin, l'autre d'arséniure de gallium et d'aluminium.

Le procédé selon l'invention est du type comportant au moins les étapes suivantes :

— réalisation, sur la couche semiconductrice active du transistor, d'un masque constitué par un premier matériau, isolant ou semi-isolant, comportant des fenêtres déterminant les dimensions et l'emplacement définitif de la source, de la grille et du drain du transistor à réaliser ;

— dépôt d'une couche d'un deuxième matériau isolant, attaquable sélectivement par un agent qui n'attaque pas ou attaque à vitesse beaucoup plus faible le premier matériau ;

— ouverture, par photogravure effectuée à l'aide dudit agent, de fenêtres de source et de drain mettant à nu le semiconducteur ;

— dépôt des contacts ohmiques de source et de drain ;

— ouverture, par photogravure effectuée à l'aide dudit agent, dans le deuxième matériau, d'une fenêtre dégageant la fenêtre initiale de grille plus grande que celle-ci, et mettant à nu, dans celle-ci, le semiconducteur ;

— dépôt du contact de grille.

Le procédé est caractérisé en ce que le premier matériau isolant ou semi-isolant est de l'arséniure de gallium polycristallin et le deuxième matériau isolant est de l'arséniure de gallium et d'aluminium, l'ordre d'utilisation des matériaux pouvant être inversé.

L'invention sera mieux comprise, et d'autres caractéristiques apparaîtront, au moyen de la description qui suit, et des dessins qui l'accompagnent, parmi lesquels :

Les figures 1 à 9 représentent différents stades du procédé selon l'invention ;

La figure 10 représente un transistor à effet de champ réalisé par le procédé selon l'invention.

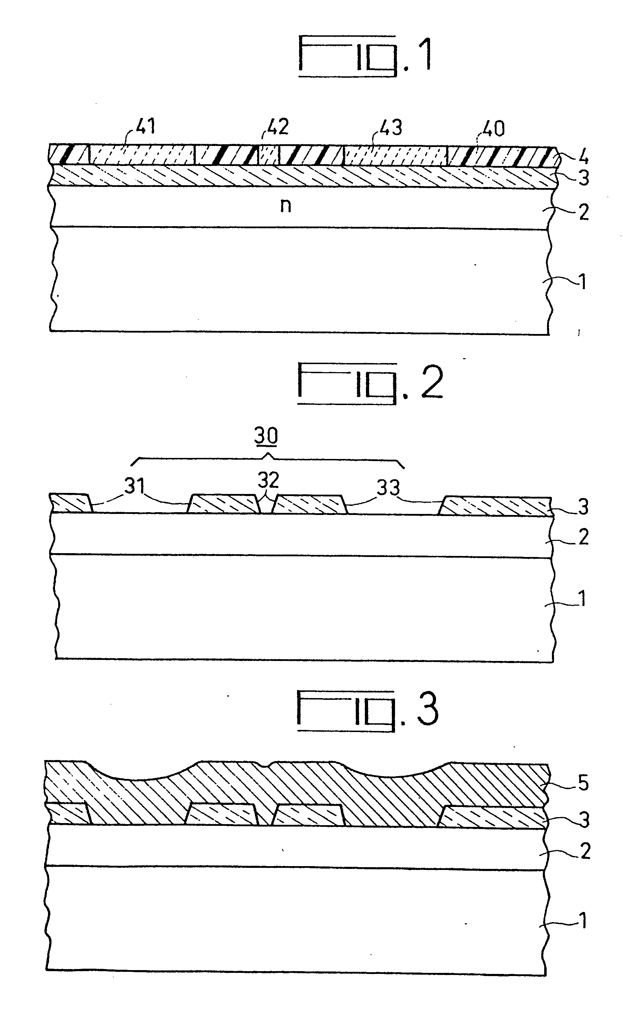

Figure 1, on a représenté, une fraction d'un substrat 1 en arséniure de gallium monocristallin, semi-isolant, sur lequel on a fait croître, par épitaxie une couche 2 d'arséniure de gallium dopé n destinée à jouer le rôle de couche active d'un transistor à effet de champ.

Sur la couche 2 on a déposé, par une méthode classique, une couche mince 3 d'arséniure de gallium polycristallin semi-isolant.

Sur la couche 3, on a déjà procédé, au stade représenté figure 1, à l'élaboration d'un masque 4 de résine sensible à un rayonnement de courte longueur d'onde, ultra-violet ou même rayons X, dans le cas où l'on désire une excellente résolution.

Dans le masque 4, représenté avant développement de la résine, on trouve des régions 41, 42, et 43 où la résine irradiée est devenue soluble dans l'agent de développement, alors que le reste 40 du masque est insoluble.

Sur la figure 2 on a représenté la plaquette de la figure 1, après traitement, recouverte d'un masque 30 comportant trois fenêtres 31, 32 et 33. Ce masque a été obtenu en développant la résine 3 puis en attaquant la plaquette à l'aide d'un agent capable d'éliminer les parties non protégées du matériau de la couche 3. On a représenté le résultat obtenu après élimination du reste 40 de la résine 4. L'attaque est effectuée soit par usinage ionique, soit par attaque chimique à l'aide d'un agent auquel la résine est peu sensible, soit de préférence à l'aide d'un réacteur de gravure à plasma localisé mettant en œuvre un gaz choisi en fonction du matériau à attaquer sélectivement.

Au stade suivant, (figure 3), on a déposé une couche 5, beaucoup plus épaisse (de l'ordre du demi-micron si la couche 3 est de l'ordre du dixième de micron) d'un deuxième matériau, lequel est également isolant ou semi-isolant, se distinguant du premier par la possibilité d'une attaque sélective. On utilisera l'arséniure de gallium et d'aluminium si le premier matériau est de l'arséniure de gallium pur. Ce pourrait être l'inverse.

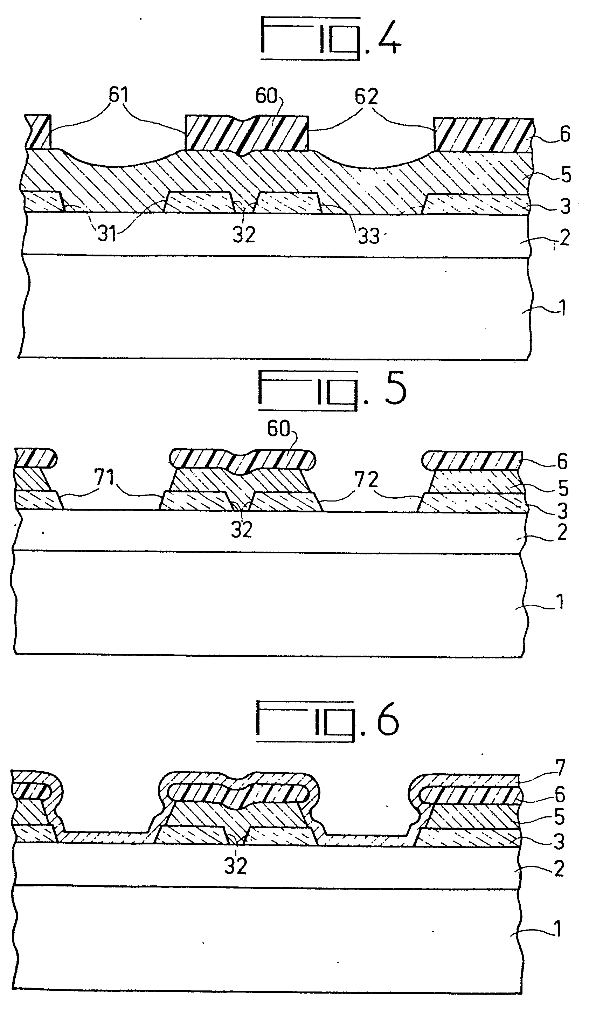

Figure 4, on a représenté la plaquette de la figure 3 après élaboration d'un masque 6 de résine comportant deux fenêtres situées aux emplacements des futurs source et drain, soit au droit des fenêtres 31 et 33 du masque 30. Il n'est pas nécessaire de déterminer avec une grande précision l'emplacement et la dimension de chaque ouverture car il suffit de s'assurer de la protection effective de la fenêtre 32 (actuellement comblée par le deuxième matériau), par le pion de résine 60 constituant la partie centrale du masque 6. En pratique, on adopte une tolérance sur les dimensions conduisant à avoir des fenêtres 61 et 62 légèrement plus larges que les fenêtres 31 et 32. La résine utilisée pour élaborer le masque 30 peut être du type photosensible.

Figure 5, on a représenté le résultat obtenu après attaque du deuxième matériau. Cette attaque peut être effectuée soit en utilisant, des agents chimiques sélectifs, soit un réacteur de gravure à plasma localisé. Elle produit des fenêtres 71 et 72 mettant à nu le matériau de la couche 2.

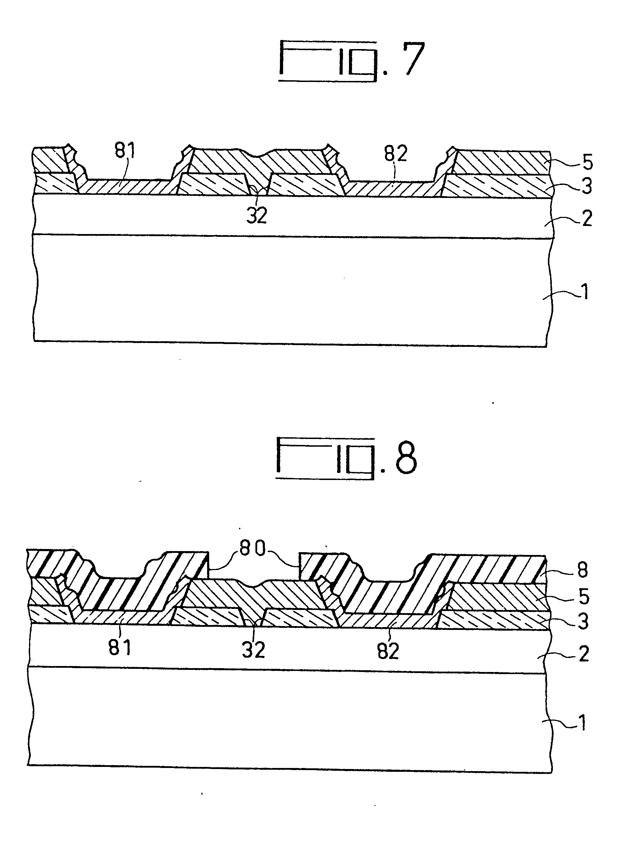

Figure 6, on a représenté la plaquette de la figure 5 après dépôt d'une couche 7 obtenue par évaporation sous vide de métal sur l'ensemble de la plaquette, la résine 6 étant laissée telle qu'elle était à la fin de l'étape précédente.

Figure 7 on a représenté la plaquette après développement par un solvant qui élimine la résine 6 selon la technologie connue dans la littérature anglo-saxonne sous le vocable de « lift-off ». Dans une telle opération la partie de la couche de métal recouvrant la résine est enlevée en même temps que la résine qui lui servait de support. Le reste de la couche susbiste et constitue les contacts ohmiques 81 et 82.

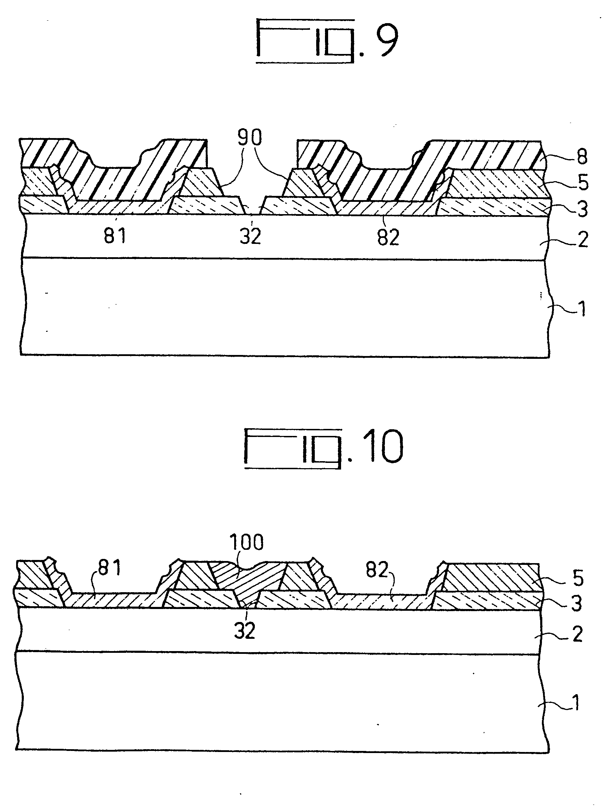

Figure 8 on a représenté la plaquette de la figure 7 après élaboration d'un masque 8 de résine photosensible comportant une fenêtre 80 située à l'emplacement de la future grille, soit au droit de la fenêtre 32 du masque constitué par le premier matériau semi-isolant, fenêtre actuellement comblée par le deuxième matériau. Les dimensions de la fenêtre 80 sont à dessein beaucoup plus larges que celles de la fenêtre 32.

Figure 9, on a représenté la plaquette de la figure 8 après attaque du deuxième matériau semi-isolant, attaque effectuée de l'une des manières déjà citée à propos de la figure 5. Le résultat est constitué par l'ouverture d'une fenêtre 90 donnant largement accès à la fenêtre 32 dans laquelle le matériau de la couche 2 a été mis à nu.

Figure 10 on a représenté le résultat obtenu après dépôt d'une couche de métal dont il ne subsiste qu'un pion 100 remplissant la fenêtre 90. Ce dépôt a été effectué par évapoation sous vide de métal suivi d'une opération de « lift-off » mettant à nu le reste de la plaquette, notamment la région des contacts 81 et 82 de source et de drain. Le pion 100 réalise le contact de grille, du type Schottky.

La structure de la figure 10 constitue celle d'un transistor à effet de champ dont la couche de passivation comporte deux matériaux différents. On a ainsi un composant pratiquement prêt à l'utilisation. Dans le cas de fabrication collective d'un grand nombre de transistors identiques sur une même plaquette (un seul d'entre eux a été représenté aux figures 1 à 10) on doit procéder toutefois à la séparation des composants par une méthode mécanique ou chimique ou une combinaison de ces deux types de méthodes, de façon classique.

Outre les avantages propres de l'auto-alignement notamment en ce qui concerne le décentrage intentionnel de la grille dans l'intervalle source-drain, on signalera :
— la forme du « pion » métallique réalisant le contact de grille, de nature à faciliter le raccordement de la connexion de grille du transistor à effet de champ ;
— la bonne protection de la couche active réalisée par les deux couches successives de matériau semi-isolant, protection réalisée immédiatement après la formation de la couche 2 ;
— l'évacuation vers la périphérie des charges prisonnières de la couche semi-isolante en évitant ainsi une source indésirable de bruit parasite, notamment en ce qui concerne le bruit dit « en 1/f » ;
— la possibilité d'appliquer le procédé selon l'invention aux transistors de forte puissance.

**Revendications**

1. Procédé de réalisation d'un transistor à effet de champ à grille Schottky auto-alignée, du type comportant au moins les étapes suivantes :
— réalisation, sur la couche semiconductrice active du transistor (2), d'un masque constitué par un premier matériau, isolant ou semi-isolant, comportant des fenêtres (31, 32, 33) déterminant les dimensions et l'emplacement définitif de la source, de la grille et du drain du transistor à réaliser ;
— dépôt d'une couche d'un deuxième matériau isolant (5), attaquable sélectivement par un agent qui n'attaque pas ou attaque à vitesse beaucoup plus faible le premier matériau ;
— ouverture, par photogravure effectuée à l'aide dudit agent, de fenêtres de source (71) et de drain (72) mettant à nu le semiconducteur ;
— dépôt des contacts ohmiques de source (81) et de drain (82) ;
— ouverture, par photogravure effectuée à l'aide dudit agent, dans le deuxième matériau, d'une fenêtre (90) dégageant la fenêtre initiale de grille (32), plus grande que celle-ci, et mettant à nu, dans celle-ci, le semiconducteur ;
— dépôt du contact de grille Schottky (100) ; le procédé étant caractérisé en ce que la couche active étant en arséniure de gallium monocristallin, le premier matériau isolant ou semi-isolant est de l'arséniure de gallium polycristallin et le deuxième matériau isolant est de l'arséniure de gallium et d'aluminium, l'ordre d'utilisation des matériaux pouvant être inversé.

2. Procédé de réalisation suivant la revendication 1, caractérisé en ce qu'il comporte en outre les étapes suivantes :

a) Irradiation, à travers un masque, d'une couche de résine (4) sensible à un rayonnement de courte longueur d'onde déposée sur une plaquette semiconductrice comportant un substrat semi-isolant (1), la couche semiconductrice active (2) et une première couche de passivation constituée par le premier matériau (3) ;

b) Développement de la couche de résine (4), et élimination du premier matériau (3) dans les parties de la première couche de passivation qui ne sont pas protégées par la résine ;

c) Élaboration d'un deuxième masque de résine (6) photosensible comportant des fenêtres aux emplacements des futurs source et drain sur la deuxième couche de passivation ;

d) Dépôt d'une couche métallique (7) par évaporation d'un métal sur la plaquette ;

e) Enlèvement par « lift-off » de la couche de métal déposée à l'étape précédente, ne laissant ainsi subsister que les contacts de source (81) et de drain (82) ;

f) Élaboration d'un troisième masque (8) de résine photosensible comportant, à l'emplacement de la future grille, une ouverture (80) plus grande que la future grille ;

g) Dépôt d'une deuxième couche métallique par évaporation d'un métal sur la plaquette après l'ouverture des fenêtres (90) et (92) ;

h) Enlèvement par « lift-off » de la couche de métal déposée à l'étape précédente, ne laissant ainsi subsister que le contact de grille (100).

3. Transistor à effet de champ réalisé par un procédé suivant l'une quelconque des revendications 1 et 2, caractérisé en ce qu'il comporte un contact de grille (100) dont la surface disponible pour le raccordement d'une connexion électrique est plus grande que la surface en contact avec la couche semiconductrice active (2).

## Claims

1. A process of manufacturing a self-aligned field-effect Schottky grid transistor of the type comprising the steps of :

— providing on the active semiconductive layer (2) of the transistor a mask (3) constituted by a first isolating or semi-isolating material and having windows (31, 32, 33) determining the final location and dimensions of the source, the grid and the drain of the transistor to be manufactured ;

— depositing of a second layer (5) of isolating material which is adapted to be attacked selectively by an agent that does not attack, or attacks only at a substantially lower speed, said first material ;

— opening up, by photogravure carried out by means of said agent, source and drain windows (71 and 72) which bare said semiconductor ;

— depositing ohmic source and drain contacts (81 and 82) ;

— opening up, by photogravure carried out by means of said agent, a window (90) in said second material, which window clears the initial grid window (32) and is larger than the same, and which bares the semiconductor in said grid window ;

— depositing the Schottly grid contact (100) said process being characterized in that the active layer is made of monocrystalline gallium arsenide, said first isolating or semi-isolating material is polycrystalline gallium arsenide, and the second isolating material is gallium-aluminium arsenide, the order of utilization of said materials being possibly reversed.

2. A manufacturing process according to claim 1, characterized in that it further comprises the following steps :

a) irradiating, through a mask, a resin layer (4) which is sensitive to short-wave radiation and which is deposited on a semiconductive plate comprising a semi-isolating substrate (1), said semiconductive active layer (2) and a first passivating layer constituted by said first material (3) ;

b) developing the resin layer (4) and eliminating said first material (3) in the portions of said first passivation layer which are not protected by the resin ;

c) providing on the second passivation layer a second mask made of light-sensitive resin and comprising windows at the locations of the future source and drain ;

d) depositing a metallic layer (7) by vaporizing a metal onto the plate ;

e) removing by the « lift-off » method the metallic layer deposited during the preceding step, so as to leave intact only the source and drain contacts (81 and 82) ;

f) providing a third mask (8) made of light-sensitive resin and comprising at the location of the future grid an opening (80) larger than said future grid ;

g) depositing a second metallic layer by vaporizing a metal onto the plate after opening up the windows (90 and 92) ;

h) removing by the « lift-off » method the metallic layer deposited during the preceding step, so as to leave intact only the grid contact (100).

3. A field-effect transistor manufactured by a process according to any one of claims 1 and 2, characterized in that it comprises a grid contact (100) the surface of which, that is available for establishing an electric connection, is larger than the surface in contact with the active semiconductive layer (2).

## Ansprüche

1. Verfahren zum Herstellung eines selbstausrichtenden Feldeffekt-Schottky-Gittertransistors, mit folgenden Verfahrensschritten :

— Herstellung einer auf einer aktiven Halbleiterschicht (2) des Transistors angeordneten Maske (3) aus einem ersten isolierenden oder halbisolierenden Material, mit die endgültige Lage der Quelle, des Gitters und des Drains des herzustellenden Transistors bestimmenden Fenstern (31, 32, 33) ;

— Aufbringen einer Schicht (5) aus einem zweiten isolierenden Material, das selektiv durch eine Substanz angreifbar ist, welcher das erste Material nicht oder nur erheblich langsamer angreift ;

— Oeffnen von Quellen- und Drainfenstern (71 bzw. 72) durch Entblössen des Halbleiters vermittels Photogravur mit Hilfe der genannten Substanz ;

— Anbringen der ohmischen Quellen- und Drainkontakte (81 bzw. 82) ;

— Oeffnen eines das ursprüngliche Gitterfenster (32) freilegenden Fensters (90), das grösser ist, als das ursprüngliche Gitterfenster, durch mit Hilfe der gennanten Substanz erfolgende Photogravur, wobei der Halbleiter im ursprünglichen Gitterfenster entblösst wird ;

— Aufbringen des Schottky-Gitterkontaks (100), dadurch gekennzeichnet, dass die aktive Schicht aus monokristallinem Galliumarsenid besteht, während das erste isolierende oder halbisolierende Material polykristallines Galliumarsenid ist und das zweite isolierende Material Gallium-Aluminiumarsenid ist, wobei die Reihenfolge der Verwendung dieser Materialen umgekehrt werden kann.

2. Herstellungsverfahren nach Anspruch 1, dadurch gekennzeichnet, dass es ferner folgende Verfahrensschritte umfasst :

a) durch eine Maske hindurch erfolgendes Bestrahlen kurzwellenstrahlenempfindlichen Harzschicht (4), die auf einem Plättchen aufgebracht ist, welches eine halbisolierende Trägerschicht (1), die aktive Halbleiterschicht (2), sowie eine aus dem ersten Material bestehende erste Passivierungsschicht (3) aufweist ;

b) Entwickeln der Harzschicht (4) und Entfernen des ersten Materials (3) von denjenigen Teilen der ersten Passivierungsschicht, die von dem Harz nicht geschützt sind ;

c) Herstellung einer zweiten Maske (6) aus lichtempfindlichem Harz, die an den Stellen der künftigen Quelle und des künftigen Drains auf der zweiten Passivierungsschicht Fenster aufweist ;

d) Aufbringen einer Metallschicht (7) durch Aufdampfen eines Metalls aus das Plättchen ;

e) Entfernen durch das « Lift-off »-Verfahren der im vorhergehenden Verfahrensschritt aufgebrachten Metallschicht, derart, dass lediglich die Quellen- und Drainkontakte (81 bzw. 82) verbleiben ;

f) Herstellung einer dritten Maske (8) aus lichtempfindlichem Harz, die an der Stelle des künftigen Gitters eine Oeffnung (80) besitzt, welche grösser ist, als das künftige Gitter ;

g) Aufbringen einer zweiten Metallschicht durch Aufdampfen eines Metalls auf das Plättchen nach dem Oeffnen der Fenster (90 und 92) ;

h) Entfernen durch das « Lift-off »-Verfahren der im vorhergehenden Verfahrensschritt aufgebrachten Metallschicht, derart, dass lediglich der Gitterkontakt (100) verbleibt.

3. Vermittels des Verfahrens nach Anspruch 1 oder 2 hergestellter Feldeffekttransistor, dadurch gekennzeichnet, dass er einen Gitterkontakt (100) besitzt, dessen zum Herstellen einer elektrischen Verbindung verfügbare Oberfläche grösser ist, als die mit der aktiven Halbleiterschicht (2) in Berührung stehende Oberfläche.

# Fig.1

41    42    43    40

4
3
n    2

1

# Fig.2

30

31    32    33

3
2

1

# Fig.3

5
3
2

1

## FIG. 4

61  60  62

6

5

3

31  32  33  2

1

## FIG. 5

60

6

71  72  5

3

32  2

1

## FIG. 6

7

6

5

3

32  2

1

Fig. 7

Fig. 8

## FIG.9

## FIG.10